# EUROPÄISCHE PATENTSCHRIFT

(11) **EP 0 396 787 B1**
(45) Veröffentlichungstag und Bekanntmachung des Hinweises auf die Patenterteilung: **12.01.1994**
(21) Anmeldenummer: 89108256.2
(22) Anmeldetag: 08.05.1989
(51) Int. Cl.: H03M 3/02

(54) **Integrierbarer Sigma-Delta-Modulator in Switched-Capacitor-Technik**
Integrable sigma-delta modulator of the switched-capacitor type
Modulateur sigma-delta intégrable utilisant la technique des capacités commutées

(43) Veröffentlichungstag der Anmeldung: 14.11.1990
(73) Patentinhaber: SIEMENS AKTIENGESELLSCHAFT, 80333 München (DE)
(72) Erfinder: Koch, Rudolf, Dr. Ing., D-8025 Unterhaching (DE)

(56) Entgegenhaltungen:
- US-A- 4 232 302
- US-A- 4 677 422
- PROCEEDINGS OF THE IEEE 1988 CUSTOM INTEGRATED CIRCUITS CONFERENCE, Rochester, New York, 16. - 19. Mai 1988, Seiten 21.3.1-21.3.4, IEEE, New York, US; S.R. NORSWORTHY et al.: "A 13-bit, 160 kHz sigma-delta A/D converter for ISDN"
- PATENT ABSTRACTS OF JAPAN, Band 9, Nr. 150 (E-324)[1873], 25. Juni 1985; & JP-A-60 31 315 (NIPPON DENKI K.K.) 18-02-1985

## Beschreibung

Die Erfindung betrifft einen integrierbaren Sigma-Delta-Modulator in Switched-Capacitor-Technik nach dem Oberbegriff des Patentanspruches 1.

Die Realisierung hochauflösender und hochlinearer Analog-Digital-Wandler mit Widerstands-, Transistor- oder Kondensatornetzwerken ist derzeit nur mit irgendeiner Form von Abgleich oder Korrektur möglich. Für manche Anwendungsfälle stellen daher Analog-Digital-Wandler mit Überabtastung und Rauschfilterung eine praktikable Lösung dar. Dabei wird mit einer hohen Abtastfrequenz statt mit einer hohen Auflösung gearbeitet und in einem nachfolgenden digitalen, also unkritischen Filter, aus dem hochfrequenten Signal geringer Auflösung ein niederfrequentes Signal hoher Auflösung gewonnen.

Ein derartiger Analog-Digital-Wandler ist beispielsweise durch einen Sigma-Delta-Modulator zweiter Ordnung mit nachgeschaltetem Filter gegeben. Eine vereinfachte Beschreibung dieses Wandlertyps ist möglich, wenn ein Komparator (= 1-Bit-Analog-Digital-Wandler) als lineares Element mit der Übertragungsfunktion H = 1 betrachtet und ein zusätzliches unkorreliertes Quantisierungsrauschen N als Störgröße eingeführt wird. Daraus ergibt sich für das Ausgangssignal dieses Wandlers, daß das Eingangssignal linear übertragen wird und das Rauschen eine Hochpaßfilterung erfährt. Ein üblicher Sigma-Delta-Modulator zweiter Ordnung weist beispielsweise zwei Integratoren (=zweiter Ordnung), zwei Digital-Analog-Wandler und einen Komparator auf. Der erste Integrator ist dabei mit der Summe aus dem Eingangssignal des Sigma-Delta-Modulators und aus dem Ausgangssignal des ersten Digital-Analog-Wandlers beaufschlagt, während an den Eingang des zweiten Integrators die Summe aus dem Ausgangssignal des ersten Integrators und aus dem Ausgangssignal des zweiten Digital-Analog-Wandlers gelegt ist. Das Ausgangssignal des zweiten Integrators wird dem Komparator zugeführt. Der Ausgang des Komparators steuert die beiden Digital-Analog-Wandler direkt oder über Speicherelemente an.

Die Unempfindlichkeit gegen Parameterschwankungen kann jedoch weiter erhöht werden, wenn der Sigma-Delta-Modulator nicht mit RC-Gliedern zur Bestimmung der Zeitkonstanten, beispielsweise der Integratorzeitkonstanten, realisiert wird, sondern in Switched-Capacitor-Technik. Hierbei werden die Zeitkonstanten nicht mehr von der absoluten Größe eines Widerstandes R und eines Kondensators C bestimmt, sondern von dem wesentlich geringeren Schwankungen unterworfenen Verhältnis zweier Kondensatoren. Eine gattungsgemäße Realisierung eines Sigma-Delta-Modulators in Switched-Capacitor-Technik ist beispielsweise aus S.R.Norsworthy and I.G. Post, "A 13-Bit, 160 kHz Sigma-Delta A/D Converter for ISDN", Proceedings of the IEEE 1988, Custom Integrated Circuits Conference, May 1988, Seiten 21.3.1 bis 21.3.4, bekannt.

Bei Sigma-Delta-Modulatoren wird prinzipgemäß mit Überabtastung, also mit hoher Taktfrequenz, gearbeitet. Die Bandbreite der Integratoren bzw. der dabei verwendeten Operationsverstärker wiederum liegt einen bestimmten Faktor über dieser Taktfrequenz, um ein hinreichend genaues Einschwingen der Integratoren bzw. der Operationsverstärker während jeder Taktperiode zu gewährleisten. Damit muß die Bandbreite der Integratoren bzw. der Operationsverstärker erheblich höher liegen als die höchste zu verarbeitende Frequenz. Die erreichbare Bandbreite der Operationsverstärker stellt daher häufig die Grenze für die Realisierbarkeit eines überabtastenden Analog-Digital-Wandlers in Switched-Capacitor-Technik dar.

Aus der amerikanischen Patentschrift 4 232 302 ist dazu bekannt, bei einem Analog-Digital-Wandler zwei parallele Abtast-Halteglieder vorzusehen, diese gegenphasig zu takten und den weiteren Signalweg bis zum Speicherelement doppelt auszuführen, um die Geschwindigkeit insgesamt zu erhöhen bzw. die Anforderungen an die Operationsverstärker und Komparatoren zu senken.

Aufgabe der Erfindung ist es, bei einem Sigma-Delta-Modulator in Switched-Capacitor-Technik die Anforderungen an die Integratoren bzw. Operationsverstärker hinsichtlich der Bandbreite zu senken.

Diese Aufgabe wird bei einem gattungsgemäßen Sigma-Delta-Modulator durch die kennzeichnenden Merkmale des Patentanspruches 1 gelöst. Ausgestaltungen des Erfindungsgedankens sind in Unteransprüchen gekennzeichnet.

Vorteil der Erfindung ist, daß die an dem eingangsseitigen Integrator bzw. Operationsverstärker auftretende effektive Taktfrequenz halbiert wird und daher entweder die Bandbreite des Integrators/Operationsverstärkers auf die Hälfe reduziert oder insgesamt die Taktfrequenz verdoppelt und damit die Auflösung erhöht werden kann, ohne dabei den Bauteileaufwand insgesamt zu verdoppeln.

Die Erfindung wird nachfolgend anhand von dem in den Figuren der Zeichnung dargestellten Ausführungsbeispiels näher erläutert, wobei gleiche Elemente mit gleichen Bezugszeichen versehen sind.

Es zeigt:
- FIG 1: eine Ausführungsform eines erfindungsgemäßen Sigma-Delta-Modulators in Switched-Capacitor-Technik und
- FIG 2: den Verlauf der Schaltphasen bei der Ausführungsform nach FIG 1.

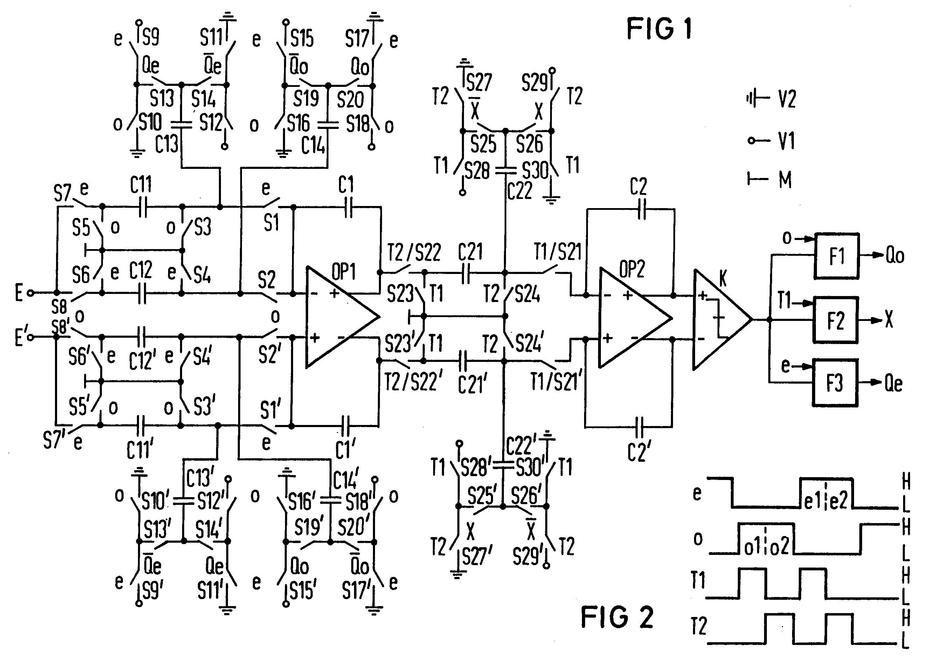

Gemäß FIG 1 der Zeichnung sind bei dem gezeigten Ausführungsbeispiel zwei Operationsverstärker OP1, OP2 vorgesehen. Bei dem ersten Operationsverstärker OP1 ist zwischen nichtinvertiertem Ausgang und invertierendem Eingang eine Kapazität C1 und zwischen invertiertem Ausgang und nichtinvertierendem Eingang eine Kapazität C1' geschaltet. Der nichtinvertierende Eingang des ersten Operationsverstärkers OP1 ist zum einen über einen Schalter S1 über einen Kondensator C11 und über einen Schalter S7 und zum anderen über einen Schalter S2, einen Kondensator C12 und einen Schalter S8 mit einem Eingang E verbunden. Darüber hinaus ist der dem Eingang E zugewandte Anschluß des Kondensators C11 über einen Schalter S5 und dessen dem Eingang E abgewandter Anschluß über einen Schalter S3, sowie der dem Eingang E zugewandte Anschluß des Kondensators C12 über einen Schalter S6 und dessen dem Eingang E abgewandte Anschluß über einen Schalter S4 auf ein Bezugspotential M aufschaltbar. Desweiteren ist an dem durch den Kondensator C11, den Schalter S3 und den Schalter S1 gebildeten Knotenpunkt ein Kondensator C13 angeschlossen. Der andere Anschluß des Kondensators C13 ist mit zwei Schaltern S13 und S14 beaufschlagt. Dem Schalter S13 ist dabei wiederum ein auf ein Potential V1 führender Schalter S9 und ein auf ein Potential V2 führender Schalter S10 nachgeschaltet. Ebenso ist dem Schalter S14 ein auf das Potential V2 führender Schalter S11 und ein auf das Potential V1 führender Schalter S12 nachgeschaltet. An den aus dem Kondensator C12, dem Schalter S4 und dem Schalter S2 gebildeten Knotenpunkt ist ein Kondensator C14 angeschlossen, dessen anderer Anschluß mit zwei Schaltern S19 und S20 beaufschlagt ist. Dem Schalter S19 ist dabei ein auf das Potential V1 führender Schalter S15 und ein auf das Potential V2 führender Schalter S16 nachgeschaltet. Ebenso ist dem Schalter S20 ein auf das Potential V2 führender Schalter S17 und ein auf das Potential V1 führender Schalter S18 nachgeschaltet.

In gleicher Weise wie die Beschaltung zwischen dem invertierenden Eingang des Operationsverstärkers OP1 und dem Eingang E ist auch die Beschaltung zwischen dem nichtinvertierenden Eingang des Operationsverstärkers OP1 und einem Eingang E′ ausgeführt. Der nichtinvertierende Eingang des ersten Operationsverstärkers OP1 ist zum einen über einen Schalter S1′, über einen Kondensator C11′ und über einen Schalter S7′ und zum anderen über einen Schalter S2′, einen Kondensator C12′ und einen Schalter S8′ mit einem Eingang E′ verbunden. Darüber hinaus ist der dem Eingang E′ zugewandte Anschluß des Kondensators C11′ über einen Schalter S5′ und dessen dem Eingang E′ abgewandter Anschluß über einen Schalter S3′, sowie der dem Eingang E′ zugewandte Anschluß des Kondensators C12′ über einen Schalter S6′ und dessen dem Eingang E′ abgewandte Anschluß über einen Schalter S4′ auf das Bezugspotential M aufschaltbar. Desweiteren ist der durch den Kondensator C11′, den Schalter S3′ und dem Schalter S1′ gebildete Knotenpunkt ein Kondensator C13′ angeschlossen. Der andere Anschluß des Kondensators C13′ ist mit zwei Schaltern S13′ und S14′ beaufschlagt. Dem Schalter S13′ ist dabei wiederum ein auf ein Potential V1 führender Schalter S9′ und ein auf das Potential V2 führender Schalter S10′ nachgeschaltet. Ebenso ist dem Schalter S14′ ein auf das Potential V2 führender Schalter S11′ und ein auf ein Potential V1 führender Schalter S12′ nachgeschaltet. An den aus dem Kondensator C12′, dem Schalter S4′ und dem Schalter S2′ gebildeten Knotenpunkt ist ein Kondensator C14′ angeschlossen, dessen anderer Anschluß mit zwei Schaltern S19′ und S20′ beaufschlagt ist. Dem Schalter S19′ ist dabei ein auf das Potential V1 führender Schalter S15′ und ein auf das Potential V2 führender Schalter S16′ nachgeschaltet. Ebenso ist dem Schalter S20′ ein auf das Potential V2′ führender Schalter S17′ und ein auf das Potential V1 führender Schalter S18′ nachgeschaltet.

Bei dem zweiten Operationsverstärker 0P2 ist zwischen nichtinvertiertem Ausgang und invertierendem Eingang ein Kondensator C2 und zwischen invertiertem Ausgang und nichtinvertierendem Eingang ein Kondensator C2′ geschaltet. Der nichtinvertierte Ausgang des ersten Operationsverstärkers OP1 ist über einen Schalter S22, einen Kondensator C21 und einen Schalter C1 mit dem invertierenden Eingang des zweiten Operationsverstärkers OP2 verbunden. In gleicher Weise ist der invertierte Ausgang des ersten Operationsverstärkers OP1 über einen Schalter C2′, einen Kondensator C21′ und einen Schalter S21′ mit dem nichtinvertierenden Eingang des zweiten Operationsverstärkers OP2 verbunden. Darüber hinaus sind die dem ersten Operationsverstärker OP1 zugewandten Anschlüsse der beiden Kondensatoren C21 bzw. C21′ über einen Schalter S23 bzw. S23′ und die dem zweiten Operationsverstärker OP2 zugewandten Anschlüsse über jeweils einen Schalter S24 bzw. S24′ auf das Bezugspotential M aufschaltbar. An den durch den Kondensator C21, dem Schalter S24 und dem Schalter S21 gebildeten Knotenpunkt ist ein Kondensator C22 angeschlossen, dessen anderer Anschluß mit zwei Schaltern S25 und S26 beaufschlagt ist. Der Schalter S25 ist zum einen auf das Potential V2 führenden Schalter S27 und mit einem auf das Potential V1 führenden Schalter S28 verbunden. Der Schalter S26 ist mit einem auf das Potential V1 führenden Schalter S29 und mit einem auf das Potential V2 fahrenden Schalter S30 verschaltet. Entsprechend ist an den aus dem Kondensator C21′ dem Schalter S24′ und dem Schalter S21′ gebildeten Knoten ein Kondensator C22′ angeschlossen.

Der nichtinvertierte Ausgang des zweiten Operationsverstärkers OP2 ist mit dem nichtinvertierenden Eingang des Komparators K und der invertierte Ausgang des Operationsverstärkers OP2 mit dem invertierenden Eingang des Komparators K gekoppelt. Der Ausgang des Komparators K ist auf die Eingänge von drei Flip-Flops F1 bis F3 als Speicherzellen geführt, wobei am Ausgang von Flip-Flop F1 das Signal Qo, am Ausgang von Flip-Flop F2 das Signal x und Ausgang von Flip-Flop F3 das Signal Qe anliegt.

Die Schaltzyklen der Schalter S1, S1′ bis S30, S30′ sowie der der Flip-Flops F1 bis F3 orientieren sich an dem grundlegenden Verhalten zweier Schaltphasen e und o. Die zeitliche Zuordnung beider Phasen ist in FIG 2 der Zeichnung dargestellt. Zunächst ist die Phase e auf hohem Pegel H und die Phase o auf niedrigem Pegel L. Nach einem Signalwechsel der Phase e erfolgt nach kurzer Verzögerungszeit ein Signalwechsel der Phase o von niedrigem Pegel L zu hohem Pegel H. Für eine gegebene Zeit führt nun die Phase o das Signal H. Dieser Zeitraum ist in zwei Bereiche o1 und o2 aufgeteilt. Nach dem Signalübergang von H nach L der Phase o erfolgt nach kurzer Verzögerungszeit ein Signalwechsel von L nach H bei der Phase e. Nun führt die Phase e für eine gegebene Zeit das Signal H, wobei dieser Zeitraum in zwei Bereiche e1 und e2 unterteilt ist. Nach diesem Schema erfolgt nun fortlaufend die Generierung von Signalen der Phase e und der Phase o. Daraus abgeleitet werden zwei Signale T1 und T2 die dann den Pegel H führen wenn die Phase e1 oder o1 bzw. beim Signal T2 das Signal e2 oder o2 auftritt. Die einzelnen Schalter werden nun jeweils durch unterschiedliche Signale angesteuert. Dabei werden die Schalter S1, S1′, S7, S7′, S6, S6′, S4, S4′, S9, S9′ S11, S11′, S15, S15′, S17, S17′, und des Flip-Flops F3 mit dem Signal e gesteuert. Bei den Schaltern S3, S3′, S5, S5′, S8, S8′, S2, S2′, S10, S10′, S12, S12′, S16, S16′, S18, S18′, und des Flip-Flops F1 erfolgt mit dem Signal o. Die Schaltzyklen der Schalter S28, S28′, S30, S30′, S21, S21′ sowie des Flip-Flops F2 sind durch das Signal T1, die Schaltzyklen der Schalter S27, S27′, S29, S29′, S22, S22′, S24, S24′ sind durch das Signal T2 festgelegt. Desweiteren werden die Schalter S19 und S20′ mit dem invertierten und die Schalter S20 und S19′ mit dem nichtinvertierten Signal Qo sowie die Schalter S14 und S13′ mit dem invertierten und die Schalter S13 und S14′ mit dem nichtinvertieren Signal Qe angesteuert. Die Ansteuerung der Schalter S25 und S26′ erfolgt mit dem invertierten sowie die Ansteuerung der Schalter S26 und S25′ mit dem nichtinvertierten Signal x. Der Aufbau des in der Zeichnung dargestellten Sigma-Delta-Modulators ist mit Ausnahem der 3 Flip-Flops F1 bis F3 und des Komparators K im übrigen völlig symmetrisch bzgl. der invertierenden und nichtinvertierenden Eingänge der beiden Operationsverstärker OP1 und OP2.

Ein üblicher Aufbau eines Integrators ist im vorliegenden Ausführungsbeispiel ausgehend von dem Operationsverstärker OP1 in Verbindung mit dem Kondensator C1 durch den Kondensator C12 und die Schalter S2, S4, S6 und S8 gegeben. Dieser Eingangsstufe ist jedoch erfindungsgemäß eine zweite Eingangsstufe mit dem Kondensator C11 und den Schaltern S1, S3, S5, S7, parallel geschaltet. Beide Stufen sind die Erfindung ausgestaltend im wesentlichen identisch aufgebaut, um vorteilhafterweise ein gutes Gleichtaktverhalten zu erreichen. Lediglich die Ansteuerung beider Stufen erfolgt wie aus FIG 1 in Verbindung mit FIG 2 hervorgeht, gegenphasig. Hierbei wird die Tatsache ausgenutzt, daß bei dem gezeigten Integrator der Operationsverstärker OP1 jeweils nur während einer halben Schaltphase aktiv ist und während der anderen halben Schaltphase lediglich den Ausgangspegel konstant hält. Durch Parallelschaltung von zwei gleichen, aber gegenphasig getakteten Eingangsstufen ist der Operationsverstärker OP1 während jeder Taktphase aktiv. Diese Parallelschaltung zweier Eingangsstufen entspricht aber einer Verdopplung der Abtastrate, so daß die Taktrate für den Integrator halbiert werden kann und dem Operationsverstärker OP1 nun mehr die doppelte Zeit zum Einschwingen zur Verfügung steht oder daß bei gleicher Einschwingzeit die Taktrate verdoppelt werden kann.

Das eben geschilderte Grundprinzip kann aber auch auf den zweiten Integrator mit dem zweiten Operationsverstärker OP2 der gezeigten Schaltung angewandt werden. Im vorliegenden Ausführungsbeispiel ist dies jedoch nicht der Fall. Die höchsten Anforderungen innerhalb dieser Schaltung bestehen nämlich an den ersten Integrator. Nichtideale Eigenschaften des zweiten Integrators und des Komparators werden in ihren Auswirkungen jeweils um die Verstärkung der vorhergehenden Stufe (n) gemildert. In Ausgestaltung der Erfindung ist daher ein erfindungsgemäß beschalteter Integrator mit hoher Verstärkung als erster Integrator vorgesehen. Die Anforderungen an den zweiten Integrator werden dadurch erheblich reduziert. Neben der Anwendung bei Sigma-Delta-Modulatoren zweiter Ordnung ist eine Anwendung bei Modulatoren anderer Ordnung ebenso vorteilhaft.

Abschließend sei bemerkt, daß neben der gezeigten, differenziellen Ausführungsform ein unsymetrischer Aufbau möglich ist. Dabei werden beispielsweise die jeweils an den nichtinvertierenden Eingängen der Operationsverstärker anliegenden Stufen abgetrennt und die nichtinvertierenden Eingänge der Operationsverstärker OP1, OP2 sowie der invertierende Eingang des Komparators K auf Bezugspotential M gelegt.

## Patentansprüche

1. Sigma-Delta-Modulator in Switched-Capacitor-Technik mit einer von einem Eingangssignal (E) angesteuerten, mindestens einen Kondensator (C12) und mehrere Schalter (S8, S6, S4, S2) aufweisenden Eingangsstufe , einem nachgeschalteten ersten Integrierer (OP1, C1), einer nachgeschalteten, mindestens einen Kondensator (C21) und mehrere Schalter (S21, S22, S23, S24) aufweisenden Koppelstufe, einem nachgeschalteten zweiten Integrierer (OP2, C2), einem nachgeschalteten Komparator (K) und einem nachgeschalteten, ein Ausgangssignal (X) abgebendem ersten Speicherelement (F2), wobei die Schalter der Eingangsstufe und der Koppelstufe durch sich nicht überlappende Steuersignale (e, o; T1, T2) geschaltet werden,
**dadurch gekennzeichnet,**
daß eine weitere identisch aufgebaute Eingangsstufe (C11, S1, S3, S5, S7) der einen Eingangsstufe parallelgeschaltet ist,
daß die einander entsprechenden Schalter beider Eingangsstufen gegenphasig geschaltet werden und
daß die Schaltfrequenz der Schalter der Koppelstufe verdoppelt ist gegenüber der Schaltfrequenz der Schalter der Eingangsstufen.

2. Sigma-Delta-Modulator nach Anspruch 1,
**dadurch gekennzeichnet,**
daß die Eingangsstufen jeweils zwei, unter Zwischenschaltung je eines ersten Kondensators (C12, C11) in Reihe liegende erste Schalter (S6, S2; S7, S1) sowie zwei jeweils zwischen einen Anschluß des ersten Kondensators (C12, C11) und ein Bezugspotential (M) geschaltete zweite Schalter (S6, S4; S5, S3) aufweisen,
daß der ausgangsseitige Anschluß des ersten Kondensators (C12, C11) zudem jeweils mit einem Anschluß eines zweiten Kondensators (C14, C13) verbunden ist, dessen anderer Anschluß zum einen über einen dritten Schalter (S19, S13) mittels eines vierten Schalters (S15, S9) auf ein erstes Potential (V1) und mittels eines fünften Schalters (S16, S10) auf ein zweites Potential (V2) aufschaltbar ist und zum anderen über einen sechsten Schalter (S20, S14) mittels eines siebten Schalters (S18, S12) auf das erste Potential (V1) und mittels eines achten Schalters (S17, S11) auf das zweite Potential (V2) aufschaltbar ist,
daß die zweiten Schalter (S6, S4) der einen Eingangsstufe, die ersten Schalter (S7, S1) der weiteren Eingangsstufe, die vierten und achten Schalter (S15, S17; S9, S11) beider Eingangsstufen sowie ein dem Komparator (K) ebenfalls nachgeschaltetes zweites Speicherelement (F3) durch ein erstes Steuersignal (e) getaktet werden,
daß die ersten Schalter (S8, S2) der einen Eingangsstufe, die zweiten Schalter (S5, S3) der weiteren Eingangsstufe, die fünften und siebten Schalter (S16, S18, S10, S12) beider Eingangsstufen sowie ein dem Komparator (K) ebenfalls nachgeschaltetes drittes Speicherelement (F1) durch ein zum ersten Steuersignal (e) inverses zweites Steuersignal (o) getaktet werden und
daß dritter und sechster Schalter (S19, S20) der einen Eingangsstufe durch das invertierte bzw. nichtinvertierte Signal am Ausgang des dritten Speicherelements (F1) sowie dritter und sechster Schalter (S13, S14) der weiteren Eingangsstufe durch das nichtinvertierte bzw. invertierte Signal am Ausgang des zweiten Speicherelements (F3) getaktet werden.

3. Sigma-Delta-Modulator nach Anspruch 1 oder 2,
**dadurch gekennzeichnet,**
daß die Kopplungsstufe jeweils einen neunten Schalter (S22), einen dritten Kondensator (C21) und einen zehnten Schalter (S21) sowie einen zwischen jeweils einen Anschluß des dritten Kondensators (C21) und das Bezugspotential (M) geschalteten elften bzw. zwölften Schalter (S23, S24) aufweist, daß der ausgangsseitige Anschluß des dritten Kondensators (C21) zudem mit einem Anschluß eines vierten Kondensators (C22) verbunden ist, dessen anderer Anschluß zum einen über einen dreizehnten Schalter (S25) mittels eines vierzehnten Schalters (S28) auf das erste Potential (V1) und mittels eines fünfzehnten Schalters (S27) auf das zweite Potential (V2) aufschaltbar ist und
zum anderen über einen sechzehnten Schalter (S26) mittels eines siebzehnten Schalters (S29) auf das erste Potential (V1) und mittels eines achzehnten Schalters (S30) auf das zweite Potential (V2) aufschaltbar ist,
daß elfter, zwölfter, vierzehnter und achzehnter Schalter (S23, S24, S28, S30) durch ein drittes Steuersignal (T1) und neunter, zehnter, fünfzehnter und siebzehnter Schalter (S22, S21, S27, S29) durch ein zum dritten Steuersignal (T1) inverses viertes Steuersignal (T2) getaktet werden, und daß der dreizehnte Schalter (S25) durch das invertierte Signal am Ausgang des ersten Speicherelements (F2) und der sechzehnte Schalter (S26) durch das nichtinvertierte Signal am Ausgang des ersten Speicherelements (F2) getaktet wird.

4. Schaltungsanordnung nach einem der Ansprüche 1 bis 3,
**dadurch gekennzeichnet,**
daß die Integratoren, die Eingangsstufen, die Kopplungsstufe und der Komparator differentiell ausgeführt sind.

## Claims

1. Sigma-delta modulator of the switched-capacitor type, comprising an input stage driven by an input signal (E) and exhibiting at least one capacitor (C12) and a plurality of switches (S8, S6, S4, S2), a following first integrator (OP1, C1), a following coupling stage exhibiting at least one capacitor (C21) and a plurality of switches (S21, S22, S23, S24), a following second integrator (OP2, C2), a following comparator (K) and a following first storage element (F2) outputting an output signal (X), the switches of the input stage and of the coupling stage being switched by non-overlapping control signals (e, o; T1, T2), characterized in that a further identically constructed input stage (C11, S1, S3, S5, S7) is connected in parallel with one input stage, in that the mutually corresponding switches of both input stages are switched in antiphase and in that the switching frequency of the switches of the coupling stage is doubled compared with the switching frequency of the switches of the input stages.

2. Sigma-delta modulator according to Claim 1, characterized in that the input stages in each case exhibit two series-connected first switches (S6, S2; S7, S1) with interposition of one first capacitor (C12, C11) in each case, and two second switches (S6, S4; S5, S3) in each case connected between a terminal of the first capacitor (C12, C11) and a reference potential (M), in that the output-end terminal of the first capacitor (C12, C11) is additionally in each case connected to one terminal of a second capacitor (C14, C13), the other terminal of which can be connected via a third switch (S19, S13), on the one hand, to a first potential (V1) by means of a fourth switch (S15, S9) and to a second potential (V2) by means of a fifth switch (S16, S10) and can be connected via a sixth switch (S20, S14), on the other hand, to the first potential (V1) by means of a seventh switch (S18, S12) and to the second potential (V2) by means of an eighth switch (S17, S11), in that the second switches (S6, S4) of one input stage, the first switches (S7, S1) of the further input stage, the fourth and eighth switches (S15, S17; S9, S11) of both input stages and a second storage element (F3) also following the comparator (K) are clocked by a first control signal (e), in that the first switches (S8, S2) of one input stage, the second switches (S5, S3) of the further input stage, the fifth and seventh switches (S16, S18, S10, S12) of both input stages and a third storage element (F1) also following the comparator (K), are clocked by a second control signal (o) which is inverted with respect to the first control signal (e), and in that the third and sixth switches (S19, S20) of one input stage are clocked by the inverted or respectively non-inverted signal at the output of the third storage element (F1) and the third and sixth switches (S13, S14) of the further input stage ore clocked by the non-inverted or respectively inverted signal at the output of the second storage element (F3).

3. Sigma-delta modulator according to Claim 1 or 2, characterized in that the coupling stage in each case exhibits a ninth switch (S22), a third capacitor (C21) and a tenth switch (S21) and an eleventh and respectively twelfth switch (S23, S24) connected between in each case one terminal of the third capacitor (C21) and the reference potential (M), in that the output-end terminal of the third capacitor (C21) is also connected to one terminal of a fourth capacitor (C22), the other terminal of which can be connected via a thirteenth switch (S25), on the one hand, to the first potential (V1) by means of a fourteenth switch (S28) and to the second potential (V2) by means of a fifteenth switch (S27), and can be connected via a sixteenth switch (S26), on the other hand, to the first potential (V1) by means of a seventeenth switch (S29) and to the second potential (V2) by means of an eighteenth switch (S30), in that the eleventh, twelfth, fourteenth and eighteenth switches (S23, S24, S28, S30) are clocked by a third control signal (T1) and the ninth, tenth, fifteenth, and seventeenth switches (S22, S21, S27, S29) are clocked by a fourth control signal (T2) which is inverted with respect to the third control signal (T1), and that the thirteenth switch (S25) is clocked by the inverted signal at the output of the first storage element (F2) and the sixteenth switch (S26) is clocked by the non-inverted signal at the output of the first storage element (F2).

4. Circuit arrangement according to one of Claims 1 to 3, characterized in that the integrators, the input stages, the coupling stage and the comparator are constructed to be differential.

## Revendications

1. Modulateur sigma-delta selon la technique des condensateurs commutés, comportant un étage d'entrée, commandé par un signal d'entrée (E) et comportant au moins un condensateur (C12) et plusieurs interrupteurs (S8,S6,S4,S2), un premier intégrateur (OP1,C1) branché en aval, un étage de couplage branché en aval et comportant au moins un condensateur (C21) et plusieurs interrupteurs (S21,S22,S23, S24), un comparateur (K) branché en aval et un premier élément de mémoire (S2) branché en aval et délivrant un signal de sortie (X), les interrupteurs de l'étage d'entrée et de l'étage de couplage étant actionnés par des signaux de commande (e,o; T1,T2) qui ne se chevauchent pas,
caractérisé par le fait
qu'un autre étage d'entrée de même constitution (C11,S1,S3, S5,S7) est branché en parallèle avec le premier étage d'entrée,
que les interrupteurs, qui se correspondent, des deux étages d'entrée sont branchés en opposition de phase, et
que la fréquence de coupure des interrupteurs de l'étage de couplage est égale au double de la fréquence de coupure des interrupteurs des étages d'entrée.

2. Modulateur sigma-delta suivant la revendication 1, caractérisé par le fait
que les étages d'entrée comportent respectivement deux premiers interrupteurs (S6,S2;S7,S1) qui sont branchés en série moyennant respectivemment le montage intercalé d'un premier condensateur (C12,C11), ainsi que deux seconds interrupteurs (S6,S4; S5,S3), qui sont branchés respectivement entre une borne du premier condensateur (C12,C11) et un potentiel de référence (M),
que la borne, située côté sortie, du premier condensateur (C12,C11), est en outre raccordée respectivement à une borne d'un second condensateur (C14,C13), dont l'autre borne peut être raccordée, par l'intermédiaire d'un troisième interrupteur (S19,S13) et au moyen d'un quatrième interrupteur (S15,S9), à un premier potentiel (V) et au moyen d'un cinquième interrupteur (S16,S10) à un second potentiel (V2), et, d'autre part par l'intermédiaire d'un sixième interrupteur (S20,S14), et au moyen d'un septième interrupteur (S18,S12), au premier potentiel (V1) et au moyen d'un huitième interrupteur (S17,S11) au second potentiel (V2),
que les seconds interrupteurs (S6,S4) du premier étage d'entrée, les premiers interrupteurs (S7,S1) de l'autre étage d'entrée, les quatrième et huitième interrupteurs (S15,S17; S9,S11) des deux étages d'entrée ainsi qu'un second élément de mémoire (F3) également branché en aval du comparateur (K), sont commandés de façon cadencée par un premier signal de commande (e),
que les premiers interrupteurs (S8,S2) du premier étage d'entrée, les seconds interrupteurs (S5,S3) de l'autre étage d'entrée, les cinquième et septième interrupteurs (S16,S18, S10,S12) des deux étages d'entrée ainsi qu'un troisième élément de mémoire (F1) également branché en aval du comparateur (K), sont commandés de façon cadencée par un second signal de cadence (o), inverse du premier signal de cadence (e), et
que les troisième et sixième interrupteurs (S19,S20) du premier étage d'entrée sont commandés de façon cadencée par le signal inversé ou le signal non inversé présent à la sortie du troisième élément de mémoire (F1) et que les troisième et sixième interrupteurs (S13,S14) de l'autre étage d'entrée sont commandés de façon cadencée par le signal non inversé ou le signal inversé présent à la sortie du second élément de mémoire (F3).

3. Modulateur sigma-delta suivant la revendication 1 ou 2, caractérisé par le fait
que l'étage de couplage comporte respectivement un neuvième interrupteur (S22), un troisième condensateur (C21) et un dixième interrupteur (S21) ainsi que des onzième et douzième interrupteurs (S23,S24) branchés entre respectivement une borne du troisième condensateur (C21) et le potentiel de référence (M),
que la borne, située côté sortie, du troisième condensateur (C21) est en outre raccordée à une borne d'un quatrième condensateur (C22), dont l'autre borne peut être connectée, d'une part, par l'intermédiaire d'un treizième interrupteur (S25) et au moyen d'un quatorzième interrupteur, au potentiel (V1) et, au moyen d'un quinzième interrupteur (S27), au second potentiel (V2), et
peut être raccordé, d'autre part, par l'intermédiaire d'un seizième interrupteur (S26) et au moyen d'un dix-septième interrupteur (S29), au premier potentiel (V1) et, au moyen d'un dix-huitième interrupteur (S30), au second potentiel (V1),
que les onzième, douzième, quatorzième et dix-huitième interrupteurs (S23, S24, S28, S30) sont commandés de façon cadencée par un troisième signal de commande (T1) et que les neuvième, dixième, quinzième et dix-septième interrupteurs (S22, S21, S27, S29) sont commandés de façon cadencée par un quatrième signal de commande (T2), inversé par rapport au troisième signal de commande (T1), et
que le treizième interrupteur (S25) est commandé de façon cadencée par le signal inversé présent à la sortie du premier élément de mémoire (F2) et que le seizième interrupteur (S26) est commandé de façon cadencée par le signal non inversé présent à la sortie du premier élément de mémoire (F2).

4. Montage suivant l'une des revendications 1 à 3, caractérisé par le fait que les intégrateurs, les étages d'entrée, l'étage de couplage et le comparateur sont agencés sous la forme d'unités différentielles.
